# EUROPÄISCHE PATENTSCHRIFT

(11) **EP 1 127 176 B1**
(45) Veröffentlichungstag und Bekanntmachung des Hinweises auf die Patenterteilung: **29.05.2002**
(21) Anmeldenummer: 99953579.2
(22) Anmeldetag: 24.08.1999
(51) Int. Cl.: C30B 25/12, C23C 16/44

(54) **VORRICHTUNG ZUM HERSTELLEN UND BEARBEITEN VON HALBLEITERSUBSTRATEN**
DEVICE FOR PRODUCING AND PROCESSING SEMICONDUCTOR SUBSTRATES
DISPOSITIF POUR PRODUIRE ET TRAITER DES SUBSTRATS SEMICONDUCTEURS

(30) Priorität: 03.09.1998 DE 19840227
(43) Veröffentlichungstag der Anmeldung: 29.08.2001
(73) Patentinhaber: SiCED Electronics Development GmbH & Co KG, 91052 Erlangen (DE)
(72) Erfinder: RUPP, Roland, D-91207 Lauf (DE); WIEDENHOFER, Arno, D-91058 Erlangen (DE)
(74) Vertreter: Berg, Peter
(86) Internationale Anmeldenummer: DE9902645
(87) Internationale Veröffentlichungsnummer: WO0014310

(56) Entgegenhaltungen:
- WO-A-96/23913
- WO-A-97/31133
- US-A- 5 584 936
- PATENT ABSTRACTS OF JAPAN vol. 004, no. 038 (C-004), 27. März 1980 (1980-03-27) & JP 55 010436 A (NEC CORP), 24. Januar 1980 (1980-01-24)
- PATENT ABSTRACTS OF JAPAN vol. 015, no. 233 (E-1077), 14. Juni 1991 (1991-06-14) & JP 03 069113 A (FUJITSU LTD), 25. März 1991 (1991-03-25)

## Beschreibung

Die Erfindung betrifft eine Vorrichtung zum Herstellen und Bearbeiten von wenigstens einem Halbleitersubstrat bei einer hohen Temperatur mit einem Suszeptor, auf dem das wenigstens eine Halbleitersubstrat aufliegt, so daß ein guter Wärmekontakt zwischen dem Halbleitersubstrat und dem Suszeptor besteht. Dabei beinhaltet das Bearbeiten insbesondere das Beschichten von Substraten. Außerdem betrifft die Erfindung auch die Verwendung der Vorrichtung.

Die SiC-Epitaxie wird üblicherweise bei einer hohen Temperatur, d.h. bei Temperaturen von über 1300°C durchgeführt. Um hohe Wachstumsgeschwindigkeiten mit mehr als 4 µm/h zu erreichen, wird die Epitaxie auch bei Temperaturen von mehr als 1450°C durchgeführt. Die Prozeßatmosphäre besteht dabei überwiegend aus Wasserstoff mit Beimengungen von Silizium- und Kohlenstoff-haltigen Gasen wie Silan und Propan. Bei diesen Prozeßbedingungen ist die Auswahl der sich im heißen Bereich des Reaktors befindlichen Materialien ein Schlüssel zur Herstellung von SiC-Schichten mit ausreichender Reinheit, d.h. mit einem Anteil an Verunreinigungen, der unterhalb von 10¹⁵ cm⁻³ liegt. Bei allen Materialien, die im Stand der Technik bei hohen Temperaturen eingesetzt werden (z.B. Graphit, Mo, W, Ta, Nb), kommt es bei diesen Temperaturen zu einem Ausgasen (Ausdiffusion) von Verunreinigungen wie Aluminium, Bor und Titan. Bei Graphit, das als klassischer Hochtemperaturwerkstoff verwendet wird, kommt es neben der Ausgasung von Aluminium, Bor und Titan außerdem zu Reaktionen mit der Wasserstoffatmosphäre unter Bildung von Kohlenwasserstoffverbindungen, so daß in kaum kontrollierbarer Weise die Kohlenstoffkonzentration in der Prozeßatmosphäre und somit auch die Wachstumsbedingungen für die Epitaxieschicht verändert werden. Die freigesetzten Verunreinigungen aus dem Graphit oder den eingesetzten Metallen werden in die Epitaxieschicht eingebaut und verändern ebenfalls in unkontrollierbarer Weise deren elektrische Eigenschaften. Damit werden diese Schichten häufig für die Herstellung von Bauelementen unbrauchbar oder führen zu einer sehr geringen Ausbeute.

Bei der Herstellung und Bearbeitung von SiC-Epitaxieschichten werden SiC-Substrate auf einem Suszeptor positioniert und dann in einem Reaktor bei hohen Temperaturen beschichtet, geätzt und ggfs. nach Implantation ausgeheilt etc.. Eine derartige Vorrichtung zur Herstellung von hochreinen bzw. gezielt dotierten epitaxialen SiC-Schichten wird in *US 5,119,540* beschrieben. Die hohe Reinheit der epitaxialen Schichten wird dadurch erreicht, daß die Konzentration von Rest-Stickstoff in der Umgebung des Substrats bei dem CVD-Verfahren reduziert wird. Dazu werden bei der genannten Vorrichtung Unterlagen für die Substrate oder Wafer verwendet, die aus reinem SiC gefertigt sind, d.h. es werden reine SiC-Suszeptoren verwendet.

Der Nachteil von Suszeptoren aus reinem SiC ist jedoch, daß bei niedrigen Temperaturen ihre Ankopplung an eine HF-Heizung sehr schlecht ist. Ferner kommt es bei der Verwendung von SiC-Suszeptoren zu einer unerwünschten Aufwachsung von SiC auf der Rückseite der Substrate, d.h. an der Auflagestelle des Substrats auf dem Suszeptor. Außerdem ist die Herstellung der SiC-Suszeptoren sehr aufwendig und teuer.

In *WO 96*/*23913* A1 wird ein Verfahren zum Schützen eines Suszeptors beschrieben, mit dem dessen Haltbarkeit unter den Bedingungen eines Epitaxieprozesses für SiC oder III-V-Nitraten verlängert wird. Dazu wird eine Platte auf dem Suszeptor angeordnet, die aus SiC oder einer Legierung aus SiC und dem Material, das aufgewachsen wird, besteht, auf der das Substrat positioniert wird. Da jedoch die Platte wenigstens teilweise aus SiC besteht, entstehen auch in diesem Fall auf der Rückseite des Substrats unerwünschte Aufwachsungen aus SiC.

Im Stand der Technik werden außerdem Unterlagen für die Substrate, Suszeptoren und weitere Teile verwendet, die aus Graphit bestehen und mit SiC beschichtet sind. Um Rißbildung bzw. das Abplatzen der SiC-Schicht vom Graphit zu verhindern, kann die Dicke der Schicht aber höchstens etwa 100 µm betragen. Dadurch wird die Haltbarkeit der Unterlagen und Teile begrenzt, da die SiC-Schicht im Prozeß durch thermisch getriebene Transportprozesse in der Regel an einigen Stellen immer dünner wird und schließlich ganz verschwindet. Auch treten häufig Risse in der Beschichtung auf. Ein weiterer Nachteil ist auch bei den mit SiC beschichteten Graphitteilen die unerwünschte Aufwachsung auf der Auflagefläche des Substrats.

Des weiteren ist aus *JP 02-212394 A* ein Suszeptor bekannt, der aus einem Suszeptor-Kern und einem daran befestigten Wafer-Einsatz besteht. Der Kern wird hergestellt, indem eine Beschichtung auf einem Graphit-Substrat mittels CVD erzeugt wird und die Oberfläche des Kerns poliert wird. Der Wafer-Einsatz wird aus Siliciumcarbid, Siliciumnitrid, Silicium oder Quarz hergestellt.

Aus der *JP 55-010436 A* ist eine Vorrichtung zum Herstellen und Bearbeiten von mehreren Halbleitersubstraten mit einem Suszeptor, auf dem die Halbleitersubstrate aufliegen, bekannt. Die Oberfläche des Suszeptors ist mit einer Abdeckplatte aus SiC belegt, die Aussparungen für die Halbleitersubstrate aufweist, so daß die Oberfläche des Suszeptors im wesentlichen vollständig durch die Abdeckplatte bedeckt ist. Die Aussparungen sind als Vertiefungen an der Oberfläche der Abdeckplatte ausgebildet, so daß zwar eine gute, aber keine optimale Wärmeankopplung der Halbleitersubstrate an den Suszeptor gegeben ist. Außerdem ist die offenbarte Abdeckplatte relativ groß, wodurch sich eine hohe Bruchgefahr beispielsweise aufgrund von thermischem Streß ergibt.

Es ist daher Aufgabe der vorliegenden Erfindung, eine Vorrichtung zur Herstellung von Halbleitersubstraten zu schaffen, die beim Herstellungsprozeß eine vorgegebene Zusammensetzung einer Prozeßatmosphäre nicht beeinträchtigt, nicht zu einer Kontamination der aufzuwachsenden Epitaxieschicht beiträgt, die Rückseite der Halbleitersubstrate nicht verändert und kostengünstig herzustellen ist. Außerdem soll die Wärmeankopplung der Halbleitersubstrate an den Suszeptor verbessert und die Bruchgefahr der Abdeckplatte verringert werden.

Diese Aufgabe wird durch eine Vorrichtung mit den Merkmalen nach Anspruch 1 gelöst. Bevorzugte Ausführungsformen der Erfindung sind Gegenstand der Unteransprüche.

Die Lösung der obigen Aufgabe beruht im wesentlichen darauf, die Unterlage des Substrats in der Umgebung der Halbleitersubstrate möglichst vollständig mit mehreren Abdeckplatten zu belegen. Durch die Abdeckplatten wird verhindert, daß aus dem Suszeptor freigesetzte Verunreinigungen in die Atmosphäre im Prozeßraum gelangen und damit z.B. in die Epitaxieschicht auf einem der Halbleitersubstrate eingebaut werden können. Um die Abdeckung effizienter zu machen, wird der Abstand zwischen den Halbleitersubstraten und den umgebenden Abdeckplatten möglichst klein gehalten. Die Abdeckung wird aus mehreren einzelnen Abdeckplatten zusammengesetzt, um z.B. die Herstellungskosten zu reduzieren und Bruchgefahr durch thermischen Streß zu vermindern. In diesem Fall wird der Abstand sowohl zwischen den einzelnen Abdeckplatten und den Halbleitersubstraten als auch zwischen den Abdeckplatten untereinander möglichst gering gehalten.

Bei der erfindungsgemäßen Vorrichtung zum Herstellen und Bearbeiten von Halbleitersubstraten bei einer hohen Temperatur mit einem Suszeptor, auf dem die Halbleitersubstrate aufliegen, so daß ein guter Wärmekontakt zwischen den Halbleitersubstraten und dem Suszeptor besteht, sind auf der Oberfläche des Suszeptors mehrere Abdeckplatten vorgesehen, die jeweils eine Aussparung für eines der Halbleitersubstrate aufweisen, so daß die Oberfläche des Suszeptors zumindest im Prozeßgasstrom vor den Halbleitersubstraten im wesentlichen vollständig durch die Abdeckplatten und die Halbleitersubstrate bedeckt ist.

Die Abdeckung umfaßt mehrere Abdeckplatten, die untereinander und von dem Halbleitersubstrat vorzugsweise einen Abstand von weniger als 0,5 mm haben. Dadurch wird erreicht, daß durch die Zwischenräume zwischen den Abdeckplatten möglichst wenig kontaminierende Stoffe ausgasen und dadurch die Reinheit der aufwachsenden Halbleiterschicht beeinträchtigen können. Insbesondere besteht die Abdeckung aus polykristallinem SiC. Damit erzielt man eine im wesentlichen einheitliche Oberfläche in dem Reaktor, die überall gleiche optische Eigenschaften hat, was z.B. für pyrometrische Kontrollmessungen von Vorteil ist. Die Abdeckung kann aber ebenso gut aus den Metallcarbiden Molybdäncarbid MoC, Tantalcarbid TaC, Wolframcarbid WC, Niobcarbid NbC bestehen.

Damit eine gute Wärmeleitung zwischen Abdeckung und Suszeptor erreicht und eine Reaktion mit der Wasserstoffatmosphäre erschwert wird, liegt die Abdeckung vorzugsweise unmittelbar auf dem Suszeptor auf.

Die Vorrichtung wird insbesondere zur Herstellung und Bearbeitung einer Halbleiterschicht oder eines Halbleitersubstrats aus SiC verwendet.

Ein Vorteil besteht darin, daß das Substrat direkt auf dem Suszeptor liegt und nicht nur mittelbar über eine SiC-Abdeckung bzw. eine Zwischenschicht aufgeheizt wird. Damit gibt es keine unerwünschten Aufwachsungen auf der Rückseite des Substrats. Außerdem sind dadurch auch die thermischen Randbedingungen der Umgebung des Substrats die gleichen wie für das Substrat selbst, insbesondere bei einem Substrat aus SiC: In beiden Fällen wird die Wärme von der Unterlage, d.h. von dem Suszeptor durch Strahlung mit im wesentlichen derselben Wärmekopplung auf die SiC-Abdeckung und das SiC-Substrat übertragen. Dies macht die Temperaturverteilung auf dem Substrat und in seiner unmittelbaren Umgebung homogener.

Weitere Merkmale und Vorteile ergeben sich aus der folgenden Beschreibung von bevorzugten Ausführungsbeispielen, wobei Bezug genommen wird auf die beigefügten Zeichnungen.
- Figur 1: zeigt ein erstes Ausführungsbeispiel der Vorrichtung im Querschnitt.
- Figur 2: zeigt eine zweites Ausführungsbeispiel der Vorrichtung im Querschnitt.
- Figur 3A: zeigt ein Ausführungsbeispiel der Vorrichtung für mehrere Halbleitersubstrate in Draufsicht.
- Figur 3B: zeigt das Ausführungsbeispiel der Vorrichtung nach Figur 3A im Querschnitt.

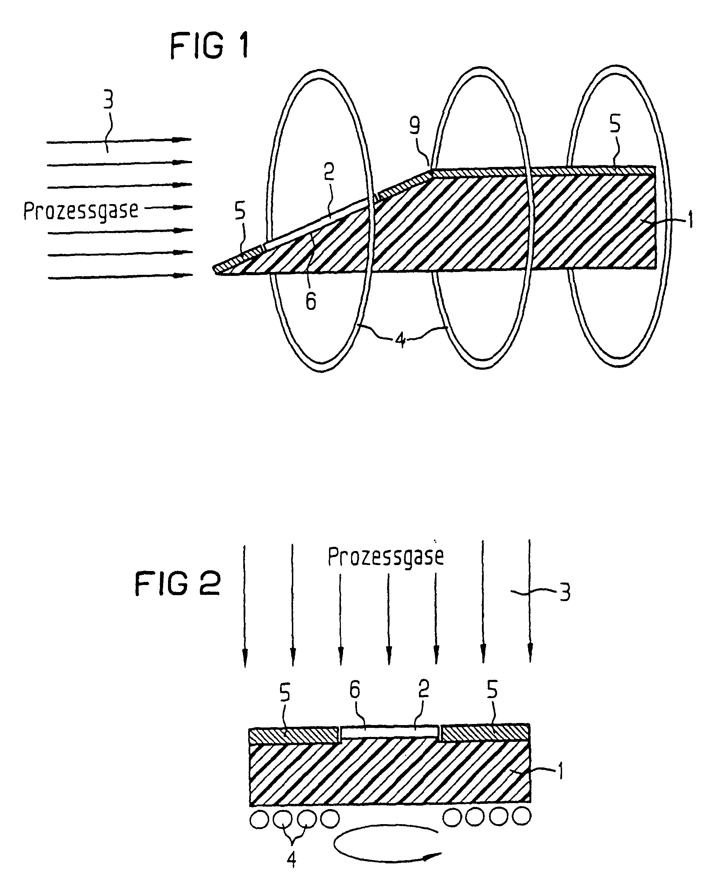

Das in Figur 1 dargestellte Ausführungsbeispiel ist ein horizontaler Reaktor, bei dem in einem (nicht dargestellten) horizontalen Quarzrohr ein Suszeptor 1 angeordnet ist, der insbesondere aus Metall oder Graphit besteht. Auf dem Suszeptor 1 ist ein zu bearbeitendes Halbleitersubstrat 2 angeordnet. Das Halbleitersubstrat 2 liegt mit einer Oberfläche vollständig auf dem Suszeptor 1 auf, so daß ein guter Wärmekontakt zwischen Suszeptor 1 und dem Substrat 2 besteht. Dadurch wird erreicht, daß über den Suszeptor 1 dem Halbleitersubstrat 2 Wärme zugeführt wird, so daß die gewünschten Reaktionen an der frei liegenden Oberfläche des Substrats 2 stattfinden können. Die gewünschten Reaktionen werden insbesondere mit Gasabscheideverfahren wie CVD eingeleitet. Dabei werden ausgewählte Prozeßgase über das oder die aufgeheizten Substrate 2 geleitet, auf denen eine gewünschte Schicht abgeschieden werden soll. Das den Suszeptor 1 anströmende Prozeßgas ist in Figur 1 mit 3 bezeichnet, und seine Flußrichtung ist durch mehrere parallele Pfeile angedeutet. Das Prozeßgas 3 ist in seiner Zusammensetzung von der beabsichtigten Bearbeitung des Halbleitersubstrats 2 abhängig. Auf der heißen Substratoberfläche kommt es zu der Reaktion der Prozeßgase, wobei die Temperatur je nach Prozeßgas in einem Bereich zwischen einigen hundert und bis zu 1600°C liegt. Die Reaktionsprodukte ergeben die gewünschte Schicht auf der Oberfläche des Substrats 2, Restgase werden aus dem Reaktor abgesaugt.

In der dargestellten Ausführungsform ist der Suszeptor 1 an der Seite, auf der das Substrat 2 angeordnet ist, abgeschrägt. Durch die Neigung des Substrats wird eine gezielt eingestellte Strömung der Prozeßgase 3 über der Oberfläche des jeweiligen Substrats 2 erreicht, so daß die Abscheidungen auf der Substratoberfläche gleichmäßig erfolgen.

Der Suszeptor 1 ist zur Abschirmung der Raumatmosphäre von den Prozeßgasen 3 vorzugsweise in einem (nicht dargestellten) Rohr angeordnet. Der Suszeptor 1 wird in der in der Figur 1 dargestellten Ausführungsform des Reaktors induktiv beheizt. Dazu ist eine das Rohr umgebenden Spule 4 vorgesehen, die mit einer HF-Spannung gespeist wird. Der Suszeptor 1 besteht aus einem Metall, wie Molybdän oder Wolfram, oder aus Graphit. Weitere Materialien, aus denen der Suszeptor hergestellt sein kann, sind Materialien, die mit dem Substrat chemisch kaum reagieren, wie neben Molybdän und Wolfram auch Tantal oder Niob. Mit anderen Worten, bei diesen Materialien kommt es nur noch zu sehr reduziertem Abtrag auf der Rückseite des Substrats 2 aus SiC durch Bildung von Metallcarbiden und - siliziden mit dem Suszeptor 1. Insbesondere kann der Suszeptor 1 auch aus einer Legierung der genannten Metalle bestehen. Ferner kann der Suszeptor auch aus Graphit hergestellt sein.

Wie oben erläutert, muß der Wärmekontakt zwischen dem Suszeptor 1 und dem Substrat 2 gut sein, damit die für die gewünschten Reaktionen an der Oberfläche des Substrats 2 erforderlichen Temperaturen erreicht werden.

Durch das Aufheizen des Suszeptors 1 auf hohe Temperaturen im Bereich von bis zu 1600°C gast das Material des Suszeptors 1 aus. Die freigesetzten Gase können zu einer erheblichen unerwünschten Verunreinigung der Halbleitersubstrate 2 führen. Um eine solche Verunreinigung zu verhindern, wird auf den heißen Flächen des Suszeptors 1 eine Abdeckung 5 angeordnet. Die Abdeckung 5 besteht vorzugsweise aus SiC oder hochtemperaturfesten Metallcarbiden. Sie weist eine Aussparung 6 auf, die so groß ist, daß sie das zu epitaxierende Substrat 2 aufnehmen kann.

Der Abstand der Abdeckung 5 von dem zu bearbeitenden Substrat 2 wird möglichst gering gehalten, damit aus den Fugen zwischen der Abdeckung 5 und dem Substrat 2 wenig Gas austreten kann, das von dem Suszeptor 1 austritt. In der Praxis hat sich ein Abstand von höchstens 0,5 mm zwischen der Abdeckung 5 und dem Substrat 2 als günstig erwiesen.

Insbesondere umfaßt die Abdeckung 5 mehrere Platten 7, die vorzugsweise aus SiC bestehen. Durch die Aufteilung der Abdeckung 5 in einzelne Platten 7 ist es möglich, flexibel die Abdeckung 5 an die Geometrie des Suszeptors 1 anzupassen, ohne für jede Form des Suszeptors 1 eine spezielle Abdeckung 5 anfertigen zu müssen. Damit lassen sich u.a. die Herstellungskosten reduzieren und die Bruchgefahr durch thermischen Streß vermindern. So kann z.B. trotz Stufen und Kanten 9 des Suszeptors 1 wie in Figur 1 die Umgebung des Substrats 2 nahezu vollständig abgedeckt werden.

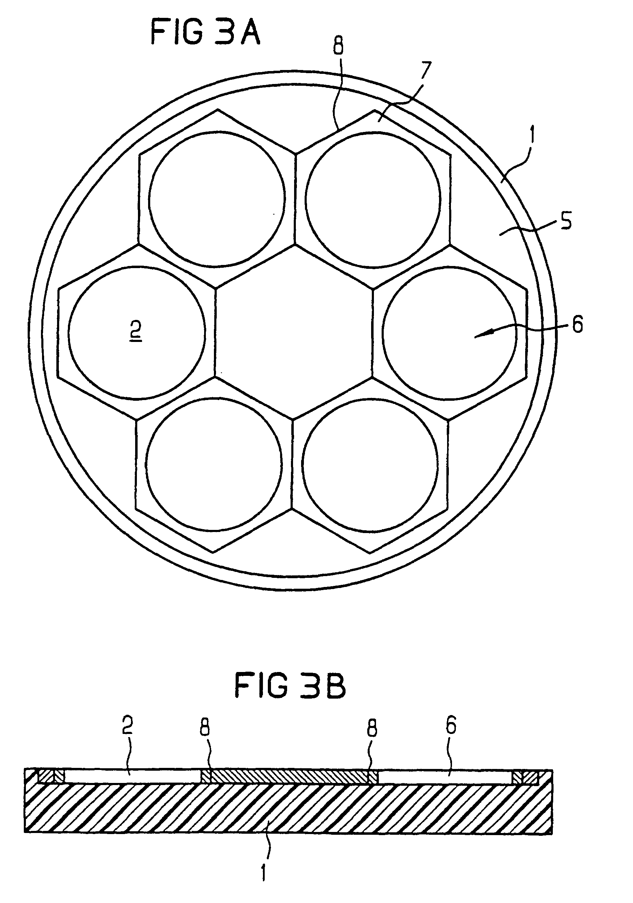

Ein zweites Ausführungsbeispiel der Vorrichtung ist in Figur 2 dargestellt. Der Suszeptor 1 ist in dieser Anordnung als Platte ausgeführt und um seinen Mittelpunkt drehbar auf einer (nicht dargestellten) Achse gelagert. Damit kann der Suszeptor 1 bei der Bearbeitung des Substrats 2 gedreht werden, wodurch eine ungleichmäßige Zufuhr von Prozeßgasen 3 oder ungleichmäßige Beheizung über einen längeren Zeitraum durch Mittelung vermieden wird. Die von den Prozeßgasen 3 angeströmte Seite des Suszeptors 1 ist von einer SiC-Abdeckung 5 mit einer Aussparung 6 für ein Substrat 2 abgedeckt. Dabei sind die Aussparung 6 und das Substrat 2 darin vorzugsweise so auf dem Suszeptor 1 angeordnet, daß das Zentrum der Aussparung 6 mit der Drehachse des Suszeptors 1 zusammenfällt. Der Suszeptor 1 wird durch eine Flachspule 4 induktiv beheizt. Der Suszeptor kann auch als umgedrehter Tiegel mit innenliegender HF-Spule 4 ausgeführt sein.

Der vertikale Reaktor nach Figur 2 eignet sich insbesondere für ein einzelnes Substrat 2 bzw. einen einzelnen Wafer (single-Wafer-Reaktor).

Eine Vorrichtung für einen vertikalen Reaktor, die sich für die Bearbeitung von mehreren Substraten (multi-Wafer-Reaktor) eignet, ist in Figur 3A in Draufsicht gezeigt. In Figur 3B ist diese Vorrichtung auch im Querschnitt dargestellt. Der Suszeptor 1 ist in dieser Anordnung ebenfalls mit Platten bedeckt, und er ist um seinen Mittelpunkt drehbar auf einer (nicht dargestellten) Achse gelagert. Im Gegensatz zu dem obigen Ausführungsbeispiel nach Figur 2 liegen jedoch jetzt mehrere Substrate auf dem Suszeptor 1. Die Größe des Suszeptors 1 wird dabei so gewählt, daß die gewünschte Anzahl von Substraten 2 darauf untergebracht werden kann. D.h. es können mehrere Substrate 2 in einem Kreis um die Achse des Suszeptors 1 herum angeordnet werden, es können aber auch weitere Substrate 2 in einem (nicht dargestellten) zusätzlichen Kreis um die Achse des Suszeptors 1 herum angeordnet werden. Auch hier wird eine (nicht gezeigte) Flachspule zur induktiven Beheizung von Suszeptor 1 und Halbleitersubstraten 2 verwendet.

Wie mit Bezug auf Figur 1 erläutert wurde, werden bei der Ausführungsform mit mehreren SiC-Abdeckplatten 7 die Substrate 2 von den SiC-Abdeckplatten 7 vollständig umschlossen, so daß im wesentlichen kein Gas aus dem Suszeptor 1 mehr in die Prozeßatmosphäre gelangen kann und zu einer unerwünschten Verunreinigung von z.B. Epitaxie-Schichten auf dem Substrat 2 beitragen kann. Aus der Darstellung nach Figur 3A wird deutlich, daß insbesondere Abdeckplatten 7, die als hexagonale Kacheln ausgeführt sind, besonders geeignet sind für eine nahezu vollständige Abdeckung der Umgebung des Substrats 2.

Der Abstand der einzelnen Platten 7 voneinander und vom zu bearbeitenden Substrat 2 wird möglichst gering gehalten, damit auch aus den Fugen zwischen den Platten 7 und zwischen Platte 7 und dem Substrat 2 wenig Gas austreten kann, das von dem Suszeptor 1 austritt. In der Praxis hat sich ein Abstand von höchstens 0,5 mm zwischen einem Rand 8 einer Platte 7 und dem Rand 8 einer benachbarten Platte 7 sowie zwischen dem Rand 8 einer Platte 7 und dem Substrat 2 als günstig erwiesen.

Um die Wärmeverteilung auf dem Substrat so homogen wie möglich zu machen, ist es notwendig, auch in der Umgebung des Substrats möglichst überall die gleiche Temperatur zu haben. Mit anderen Worten, die Temperatur auf der frei zugänglichen Oberfläche des Substrats muß die gleiche sein wie auf der Oberfläche der Abdeckung 5. Daher wird vorzugsweise die Abdeckung 5 unmittelbar auf dem Suszeptor 1 angeordnet, so daß eine gute Wärmeleitung zwischen Suszeptor 1 und Abdeckung 5 besteht. Dies ist insbesondere dann der Fall, wenn sowohl Substrat 2 als auch Abdeckung 5 aus SiC, d.h. die Abdeckung 5 aus polykristallinem hochreinem SiC besteht und damit sehr ähnliche thermische Eigenschaften wie das Substrat besitzt. Durch die Wärmekopplung zwischen dem Suszeptor 1 und der Abdeckung 5 wird so bei der Abdeckung 5 im wesentlichen die gleiche Temperatur wie dem Substrat 2 erreicht. Durch die Beschaffenheit der Abdeckung 5 aus polykristallinem hochreinem SiC wird eine besonders gute Wärmeleitung erreicht. Ferner wird mit einer Abdeckung aus polykristallinem SiC eine homogene Oberfläche aus SiC (nämlich Abdeckung 5 und Substrat 2) im Reaktor erreicht, was pyrometrische Untersuchungen zur Feststellung der Oberflächentemperatur u. dgl. vereinfacht.

Die beschriebene Vorrichtung wird insbesondere zum Herstellen/Bearbeiten von SiC-Substraten verwendet, da die Abdeckung aus SiC auch bei den für z.B. SiC-Epitaxie erforderlichen hohen Temperaturen eingesetzt werden kann.

Die Vorrichtung kann in verschiedenen Arten von Reaktoren eingesetzt werden, z.B. Heißwand- oder Kaltwandreaktor, Reaktoren, bei denen der Suszeptor direkt durch eine Heizwicklung oder eine Heizlampe beheizt wird, oder Reaktoren für "Plasma Enhanced CVD" etc..

## Patentansprüche

1. Vorrichtung zum Herstellen und Bearbeiten von Halbleitersubstraten (2) aus SiC bei einer hohen Temperatur mit einem Suszeptor (1), auf dem die Halbleitersubstrate (2) aufliegen, so daß ein guter Wärmekontakt zwischen den Halbleitersubstraten (2) und dem Suszeptor (1) besteht, **dadurch gekennzeichnet, daß** die Oberfläche des Suszeptors (1) direkt mit mehreren Abdeckplatten (7) belegt ist, die jeweils eine Aussparung (6) für eines der Halbleitersubstrate (2) aufweisen, so daß die Oberfläche des Suszeptors (1) im wesentlichen vollständig durch die Abdeckplatten (7) und die Halbleitersubstrate (2) bedeckt ist und so daß eine gute Wärmeleitung zwischen dem Suszeptor (1) und den Abdeckplatten (7) besteht.

2. Vorrichtung nach Anspruch 1, **dadurch gekennzeichnet, daß** die Abdeckplatten (7) untereinander und von dem jeweiligen Halbleitersubstrat (2) einen Abstand von weniger als 0,5 mm haben.

3. Vorrichtung nach Anspruch 1 oder 2, **dadurch gekennzeichnet, daß** die Abdeckplatte (7) aus polykristallinem SiC besteht.

4. Vorrichtung nach Anspruch 1 oder 2, **dadurch gekennzeichnet, daß** die Abdeckplatte (7) aus Metallcarbid besteht.

## Claims

1. Device for producing and processing semiconductor substrates (2) made from SiC at a high temperature using a susceptor (1), on which the semiconductor substrates (2) rest, so that there is good thermal contact between the semiconductor substrates (2) and the susceptor (1), **characterized in that** the surface of the susceptor (1) is directly covered with a plurality of cover plates (7) which each have a cutout (6) for one of the semiconductor substrates (2), so that the surface of the susceptor (1) is substantially completely covered by the cover plates (7) and the semiconductor substrates (2), and so that there is good conduction of heat between the susceptor (1) and the cover plates (7).

2. Device according to Claim 1, **characterized in that** the cover plates (7) are at a distance of less than 0.5 mm from one another and from the respective semiconductor substrate (2).

3. Device according to Claim 1 or 2, **characterized in that** the cover plate (7) consists of polycrystalline SiC.

4. Device according to Claim 1 or 2, **characterized in that** the cover plate (7) consists of metal carbide.

## Revendications

1. Dispositif de production et de traitement de substrats (2) semi-conducteurs en SiC à une température haute comprenant un suscepteur (1) sur lequel reposent les substrats (2) semi-conducteurs, de manière à ce qu'il y ait un bon contact thermique entre les substrats (2) semi-conducteurs et le suscepteur, **caractérisé en ce que** la surface du suscepteur (1) est garnie directement de plusieurs plaques (7) de recouvrement qui ont respectivement un évidement (6) pour l'un des substrats (2) semi-conducteurs, de sorte que la surface du suscepteur (1) est recouverte sensiblement complètement par les plaques (7) de recouvrement et les substrats (2) semi-conducteurs et de sorte qu'il y ait une bonne conduction de la chaleur entre le suscepteur (1) et les plaques (7) de recouvrement.

2. Dispositif suivant la revendication 1, **caractérisé en ce que** les plaques (7) de recouvrement ont entre elles et par rapport au substrat (2) semi-conducteur respectif un intervalle de moins de 0,5 mm.

3. Dispositif suivant la revendication 1 ou 2, **caractérisé en ce que** la plaque (7) de recouvrement est en SiC polycristallin.

4. Dispositif suivant la revendication 1 ou 2, **caractérisé en ce que** la plaque (7) de recouvrement est en carbure métallique.
